# EUROPÄISCHE PATENTSCHRIFT

(11) **EP 1 423 893 B1**
(45) Veröffentlichungstag und Bekanntmachung des Hinweises auf die Patenterteilung: **25.05.2005**
(21) Anmeldenummer: 02777028.8
(22) Anmeldetag: 06.09.2002
(51) Int. Cl.: H01S 5/34

(54) **UNIPOLARER QUANTENKASKADENLASER**
UNIPOLAR QUANTUM CASCADE LASER
LASER UNIPOLAIRE A CASCADE QUANTIQUE

(30) Priorität: 07.09.2001 DE 10143956
(43) Veröffentlichungstag der Anmeldung: 02.06.2004
(73) Patentinhaber: FRAUNHOFER-GESELLSCHAFT ZUR FÖRDERUNG DER ANGEWANDTEN FORSCHUNG E.V., 80636 München (DE)
(72) Erfinder: YANG, Quankui, 79194 Gundelfingen (DE); SCHNEIDER, Harald, 79276 Reute (DE); KÖLER, Klaus, 79108 Freiburg (DE)
(74) Vertreter: Rösler, Uwe, Dipl.-Phys.
(86) Internationale Anmeldenummer: PCT/EP2002/010019
(87) Internationale Veröffentlichungsnummer: WO 2003/023909

(56) Entgegenhaltungen:
- WO-A-01/26192
- US-A- 5 509 024
- US-A- 5 936 989
- US-A- 6 154 475
- US-B1- 6 278 134
- YANG Q K ET AL: "IMPROVEMENT OF LAMBDA 5 MUM QUANTUM CASCADE LASERS BY BLOCKING BARRIERS IN THE ACTIVE REGIONS" APPLIED PHYSICS LETTERS, AMERICAN INSTITUTE OF PHYSICS. NEW YORK, US, Bd. 80, Nr. 12, 25. März 2002 (2002-03-25), Seiten 2048-2050, XP001108479 ISSN: 0003-6951

## Beschreibung

### Technisches Gebiet

Die Erfindung bezieht sich auf einen unipolaren Quantenkaskadenlaser mit einer Vielzahl von in periodischer Abfolge aneinandergrenzenden Halbleiter-Vielschichtstrukturen, durch die hindurch, durch Vorsehen wenigstens zweier Kontaktstellen ein Elektronenstrom einprägbar ist, und die jeweils einen optisch aktiven Bereich, der wenigstens eine Quantenfilmstruktur aufweist, innerhalb der wenigstens ein oberes und ein unteres Energieniveau für Elektronen vorhanden sind, zwischen denen lichtemittierende Eletdronenübergänge stattfinden, sowie einen Übergangsbereich aufweisen, der eine Anzahl Halbleiterschichten aufweist, durch die hindurch Elektronen aus dem unteren Energieniveau des optisch aktiven Bereiches in das obere Energieniveau eines, an den Übergangsbereich in Elektronentransportrichtung unmittelbar angrenzenden optisch aktiven Bereich einer benachbarten Halbleiter-Vielschichtstruktur gelangen, wobei die Elektronenübergänge sowie der Elektronentransport ausschließlich im Leitungsband der Halbleiter-Vielschichtstrukturen erfolgt,

### Stand der Technik

Quantenkaskadenlaser der vorstehend genannten Gattung sind aus Halbleitermaterialien gefertigte unipolare Laserlichtquellen, die Licht mit Wellenlängen vom mittleren bis fernen Infraroten Spektralbereich, d. h. 3 - 15 µm emittieren. Insbesondere im Wellenlängenbereich zwischen 4 - 5 µm stellen Quantenkaskadenlaser derzeit die technisch am weitest fortgeschrittenen Infrarotlichtquellen dar, die auch bei relativ hohen Temperaturen technisch interessante Wirkungsgrade aufweisen.

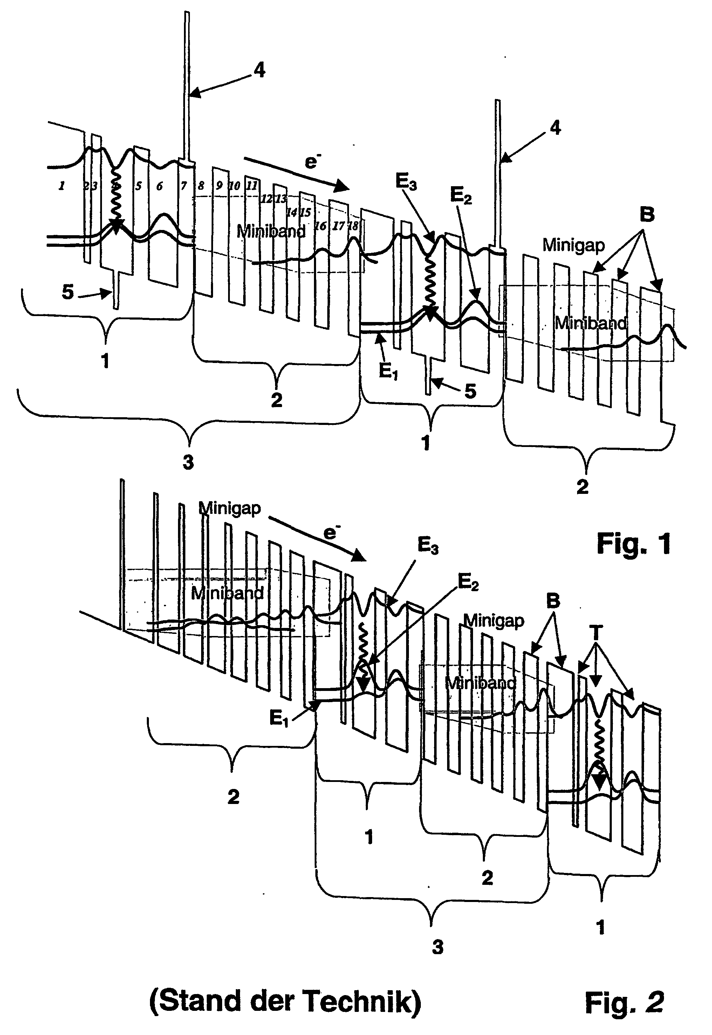

Quantenkaskadenlaser sind erst seit dem Jahr 1995 bekannt und erfahren seit dieser Zeit eine konsequente technische Weiterentwicklung, deren Ziel letztlich die Steigerung ihres Wirkungsgrades ist. Der derzeitige Entwicklungsstand derartiger Laser kann repräsentativ aus der aktuellen Patentliteratur insbesondere aus den amerikanischen Patenten US 5,457,709, US 5,509,025, US 5,745,516 sowie US 5,936,989 entnommen werden. Das Bändermodell eines bekannten Quantenkaskadenlasers, der in der vorstehenden Patentliteratur beschrieben ist, ist in Figur 2 dargestellt. Quantenkaskadenlaser setzen sich üblicherweise aus einer Vielzahl stapelförmig aneinandergereihter Halbleiter-Vielschichtstrukturen 3 zusammen, die ihrerseits in einen optischen Bereich 1 und einen Übergangsbereich 2 unterteilbar sind. Jede einzelne Halbleiter-Vielschichtstruktur 3 setzt sich aus einer alternierenden Abfolge einzelner Halbleiterschichten zusammen, die jeweils einem Halbleitermaterialsystem entstammen, das eine Schichtkombination zweier verschiedener Halbleitermaterialien vorsieht, nämlich sog. Topf- (T) und sog. Barrierenmaterialien (B), deren charakteristische Bandverläufe aus dem mäanderförmigen Verhalten der in Figur 2 gezeigten Darstellung zu entnehmen sind.

Wesentliches Merkmal des für einen unipolaren Quantenkaskadenlaser charakteristischen Bänderschemas, wie es in Figur 2 dargestellt ist, stellt die ausschließliche Beteilligung von Elektronen am Ladungsträgertransport dar, der innerhalb der optischen Bereiche sowie der daran angrenzenden Übergangsbereiche stattfindet. So finden innerhalb der optischen Bereiche lediglich Elektron-Elektron Übergänge zwischen einzelnen Subbändem statt, die zum gleichen elektronischen Band, nämlich dem Leitungsband, gehören. Damit unterscheiden sich unipolare Quantenkaskadenlaser grundsätzlich von Interband-Kaskaden-Laser bzw. kaskadierte bipolare Interband-Laser, an deren Ladungsträgertransport Elekronen und Löcher beteiligt sind.

Als derzeit besonders geeignete Halbleitermaterialsysteme für unipolare Quantenkaskadenlaser werden GaInAs/AlInAs oder InGaAs/AlAsSb, die jeweils auf einem InP-Substratgitter gitterangepasst, d. h. ohne innere Gitterspannungen, abgeschieden werden, ferner GaAs/AlGaAs auf einem GaAs-Substrat oder InAs/AlSb, das auf einem binären GaSb- oder InAs-Substrat aufgebracht wird, angesehen. Selbstverständlich gibt es auch weitere Halbleitermaterialsysteme mit denen der Aufbau eines Quantenkaskadenlasers möglich ist, wie bspw. GaAs/AlGaSb, doch sollen die weiteren Zusammenhänge ohne Einschränkung auf ein konkretes Halbleitermaterialsystem anhand des eingangs erwähnten AlInAs/GaInAs näher erläutert werden.

Die in Figur 2 dargestellten Barriereschichten B setzen sich somit allesamt aus AlInAs und die jeweils unmittelbar darauffolgenden TopfschichtT aus GaInAs zusammen. Durch Zugabe bestimmter Dotierstoffe in die einzelnen Halbleitermaterialschichten wird in an sich bekannter Weise dafür gesorgt, dass Ladungsträger in geeigneter Konzentration in der Vielschichtstruktur vorhanden sind. Das Schichtdesign der Halbleiter-Vielschichtstruktur 3, die gänzlich aus einer alternierenden Abfolge vorstehend genannter Halbleiterschichten B und T zusammengesetzt ist, mit dem optischen Bereich 1 sowie den Übergangsbereich 2, die ihrerseits für die jeweils in den entsprechenden Bereichen befindlichen Ladungsträgern unterschiedliche erlaubte Energieniveaus aufweisen, wird in an sich bekannter Weise durch Auswahl einer geeigneten Anzahl von Barrieren- und Topfschichten B und T mit geeigneten Dicken vorgenommen. So zeichnet sich der optische Bereich 1 innerhalb einer Halbleiter-Vielschichtstruktur 3 dadurch aus, dass ein konkretes oberes Energieniveau E₃ vorgesehen ist, das ein für Elektronen als Ladungsträger erlaubtes Energieniveau darstellt. Ferner sind zwei weitere, untere erlaubte Energieniveaus für Elektronen E₂ und E₁ innerhalb des optischen Bereiches vorgesehen. Die vorstehend genannten Energieniveaus sind in Figur 2 innerhalb des optischen Bereiches 1 als durchgehend markante Linien eingezeichnet, die den Verlauf einer numerisch ermittelten quadratischen Wellenfunktion (Schrödingergleichung) entsprechen. Befinden sich Elektronen im Energieniveau E₃ so findet zwischen den Energieniveaus E₃ und E₂ ein erlaubter Elektronenübergang statt, bei dem Licht emittiert wird. Um sicherzustellen, dass das Energieniveau E₂ nicht von Elektronen überfüllt bzw. belegt ist, dient ein weiteres unteres Energieniveau E₁ dazu, das Energieniveau E₂ aufgrund einer sehr kurzen Relaxationszeit zwischen E₂ und E₁ stets zu entleeren.

Demgegenüber ist der Übergangsbereich 2 in Art eines als Bragg-Reflektor wirkendes Übergitter aufgebaut und weist einen Miniband-Bereich auf, der zumindest teilweise mit den Energieniveaus E₂ und E₁ des unmittelbar angrenzenden optischen Bereiches überlappt.

Wird wie in Figur 2 dargestellt eine elektrische Vorspannung (Bias-Spannung) derart lateral zu der Vielzahl stapelförmig angeordneter Halbleiter-Vielschichtstrukturen 3 angelegt, so dass das Bändermodell den in Figur 2 schräg abfallenden Bandverlauf annimmt, so wird ein Elektronenstrom durch die Vielzahl unmittelbar aneinandergrenzender Halbleiter-Vielschichtstrukturen 3 in Elektronentransportrichtung (siehe Teildarstellung) generiert, der innerhalb der einzelnen optischen Bereiche 1 jeweils zu den lichtemittierenden Elektronenübergängen führt. Charakteristisch bei Quantenkaskadenlasern ist das namensgebende kaskadierende Verhalten der einzelnen Elektronen auf ihrem Weg durch die aneinandergrenzenden Halbleiter-Vielschichtstrukturen 3. Nach erfolgtem lichtemittierenden Energieübergang und Relaxieren in das Energieniveau E₁ innerhalb eines optischen Bereiches 1 gelangt das Elektron von diesem unteren Energieniveau E₁ in das Miniband des angrenzenden Übergangsbereiches 2, von dem es aus in ein weiteres oberes Energieniveau E₁ eines sich in Elektronentransportrichtung anschließenden weiteren optischen Bereiches 1 injiziert wird. Dort erfolgt erneut ein lichtemittierender Übergang, der sich je nach Anzahl der stapelförmig kombinierten Halbleiter-Vielschichtstrukturen 3 wiederholt.

Aus rein theoretischer Sicht könnte man erwarten, dass jedes Elektron, das in N in periodischer Abfolge aneinandergrenzenden Halbteiter-Vielschichtstrukturen injiziert wird, entsprechend N-Photonen erzeugt, so dass der theoretisch optimale externe Quantenwirkungsgrad N x 100% ist, vorausgesetzt, dass keine Verlustmechanismen auf das Elektron auf seinem Weg durch die N Halbleiter-Vielschichtstrukturen einwirken. Versuche mit Quantenkaskadenlasern, die über N = 25 aneinandergereihte Halbleiter-Vielschichtstrukturen aufwiesen, zeigten trotz nahezu optimaler Auslegung der Quantenkaskadenlaser einen externen Quantenwirkungsgrad von nur 500%, der immerhin 80% unter dem theoretisch erreichbaren externen Quantenwirkungsgrad liegt.

Die auftretenden Verluste hängen einerseits damit zusammen, dass die Lebensdauer für einen lichtemittierenden Übergang wesentlich größer ist als diejenige der nichtstrahlende Energierelaxation, die hauptsächlich unter Emission von Phononen erfolgt. Diese Tatsache führt zu einem für Quantenkaskadenlaser typischen, hohen Schwellstrom für die Lasertätigkeit Oberhalb der Laserschwelle ist die Lebensdauer des lichtemittierenden Übergangs, der nun stimuliert erfolgt, genügend kurz (kürzer als diejenige der nichtstrahlenden Relaxation), so dass eine effiziente Lichtemission erfolgt.
Andererseits spielen bei den hohen, oberhalb der Laserschwelle auftretenden Stromdichten insbesondere Tunnelprozesse eine entscheidende Rolle, durch die hochenergetische Elektronen innerhalb des oberen Energieniveaus E₃ aus dem optischen Bereich ins energetische Kontinuum gelangen und somit der Quantenkaskadenlaserstruktur ungenutzt entschwinden. Dieses Problem tritt vor allem dann auf, falls hohe optische Leistungen oder hohe Betriebstemperaturen erzielt werden sollen, was hohe Stromdichten und Verlustleistungen erfordert.

Eben diesem Verlustmechanismus entgegentretend sind in einer Reihe der eingangs zitierten amerikanischen Patentschriften Maßnahmen beschrieben, mit denen den diesbezüglichen Tunnelprozessen entgegengewirkt werden kann. Aus diesem Grunde ist das Halbleiterschichtdesign innerhalb des Übergangsbereiches 2 derart gewählt, dass nahe der Elektronenbandkantenenergie E₃ im Bereich des Übergangsbereiches keine erlaubten Energiezustände vorhanden sind, sondern vielmehr ein Minigap existiert. Dies verhindert ein Übertreten von Elektronen aus dem optischen Bereich innerhalb des Energieniveaus E₃ in den unmittelbar angrenzenden Übergangsbereich, so dass der Übergangsbereich auf diese hochenergetischen Elektronen in Art eines Bragg-Reflektors wirkt, wodurch die Elektronen innerhalb des optischen Bereiches im oberen Energieniveau E₃ regelrecht eingeschlossen werden. Trotz dieser Anstrengungen können auch mit den vorstehend genannten Maßnahmen keine besseren Wirkungsgradergebnisse erzielt werden, als vorstehend dargestellt. Es besteht daher Anlass zur Annahme, dass die bislang getroffenen Maßnahmen zur Verminderung von Verlustmechanismen, denen die Ladungsträger, insbesondere Elektronen auf ihrem Weg durch die periodische Abfolge aneinandergereihter Halbleiter-Vielschichtstrukturen unterliegen, unzureichend sind.

Der US 6,154,475 ist ein unipolarer Quantenkaskadenlaser entnehmbar, bei dem Löcher über Intersubband-Übergänge Licht emittieren. Diese Druckschrift stellt somit ein Beispiel für einen Quantenkaskadenlaser dar, der ausschließlich auf einem Löcher-Ladungsträgertransportmechanismus erfolgt.

### Darstellung der Erfindung

Der Erfindung liegt die Aufgabe zugrunde, einen unipolaren Quantenkaskadenlaser der eingangs beschriebenen Gattung derart weiterzubilden, dass trotz bislang bekannter Maßnahmen zur Reduzierung des Elektronenverlustes durch Tunnelvorgänge, wodurch Elektronen ins energetische Kontinuum gelangen, alternative, effizientere Vorkehrungen getroffen werden sollen, eben diesen Verlustmechanismus weiter entscheidend einzuschränken, Insbesondere soll ein Quantenkaskadenlaser angegeben werden, zu dessen Betrieb eine geringere Schwellstromdichte erforderlich ist, um den Laserprozess hervorzurufen und aufrecht zu erhalten und der überdies Ober einen höheren externen Wirkungsgrad und höhere Laserleistung verfügen soll.

Die Lösung der der Erfindung zugrundeliegenden Aufgabe ist im Anspruch 1 angegeben. Den Erfindungsgedanken vorteilhaft weiterbildende Merkmale sind Gegenstand der Unteransprüche sowie der Beschreibung unter Bezugnahme auf die Ausführungsbeispiele mit Figuren zu entnehmen.

Erfindungsgemäß ist ein unipolarer Quantenkaskadenlaser mit einer Vielzahl von in periodischer Abfolge aneinandergrenzenden Halbleiter-Vielschichtstrukturen, durch die hindurch, durch Vorsehen wenigstens zweier Kontaktstellen ein Elektronenstrom einprägbar ist, und die jeweils einen optisch aktiven Bereich, der wenigstens eine Quantenfilmstruktur aufweist, innerhalb der wenigstens ein oberes und ein unteres Energieniveau für Elektronen vorhanden sind, zwischen denen lichtemittierende Elektronenübergänge stattfinden, sowie einen Übergangsbereich aufweisen, der eine Anzahl Halbleiterschichten aufweist, durch die hindurch Elektronen aus dem unteren Energieniveau des optisch aktiven Bereiches in das obere Energieniveau eines, an den Übergangsbereich in Elektronentransportrichtung unmittelbar angrenzenden optisch aktiven Bereich einer benachbarten Halbleiter-Vielschichtstruktur gelangen, wobei die Elektronenübergänge sowie der Elektronentransport ausschließlich im Leitungsband der Haibieiter-Vieischichtstrukturen erfolgt, derart ausgebildet, dass wenigstens eine Blockadeschicht innerhalb der Halbleiter-Vielschichtstruktur vorgesehen ist, die aus einem Halbleiter material besteht, das unterschiedlich zu den Halbleiter materialien in der Halbleiter-Vielschicht struktur ist und die darüber hinaus ein oberes Leitungsbandkantenpotenzial aufweist, das höher ist als die obersten Bandkantenpotenziale von allen übrigen innerhalb der Halbleiter-Vielschichtstruktur enthaltenen Halbleiterschichten.

Der neue Ansatz geht im Gegensatz zur bisherigen Praxis der entsprechenden Ausbildung des Übergangsbereiches als Übergitter zur Erzeugung eines Bragg-Reflektors, von wenigstens einer zusätzlichen dünnen Schicht aus, die aus einem Halbleitermaterial besteht, das unterschiedlich zu den Materialien des betreffenden Halbleitermaterialsystems ist, aus dem der Quantenkaskadenlaser zusammengesetzt ist, und die darüber hinaus eine erhöhte obere Bandkantenenergie besitzt, so dass sie als Blockadeschicht für Elektronen, die sich im oberen Energieniveau E₃ befinden, in Elektronentransportrichtung dient.

In einer bevorzugten Anordnung ist die Blockadeschicht innerhalb des optisch aktiven Bereiches in Elektronentransportrichtung unmittelbar angrenzend zum Übergangsbereich angeordnet, so dass Elektronen im oberen Energieniveau E₃ aufgrund der erhöhten Bandkantenenergie der Blockadeschicht nahezu vollständig vor dem Entweichen in das energetische Kontinuum behindert werden. Durch geeignete Materialwahl und Schichtdesign der erfindungsgemäß zusätzlich in die Halbteiter-Vielschichtstruktur vorgesehenen Blockadeschicht ist es andererseits möglich, die Tunnetwahrscheintichkeit für Elektronen, die sich auf den unteren Energieniveaus innerhalb des optischen Bereiches befinden, derart zu einzustellen, vorzugsweise deutlich kleiner 1 zu wählen, dass die vorzugsweise auf dem untersten Energieniveau E₁ befindlichen Elektronen ohne weiteres die Blockadeschicht durchtunneln können, um in die durch das Miniband vorgesehenen erlaubten Energiezustände des in Elektronentransportrichtung benachbart vorgesehenen Übergangsbereiches übertreten zu können. Hierbei ist zu bemerken, um den unipolaren Charakter des Quantenkaskadenlasers zu verdeutlichen, dass alle Minibänder der durch Blockadeschichten voneinander getrennten optischen Breiche ein und demselben elektronischen Band angehören.

Ein besonders bevorzugtes Halbleitermaterial zur Realisierung einer derartigen Blockadeschicht stellt für Halbleitermaterialsysteme aus einer GaInAs/AlInAs- oder InGaAs/AlAsSb-Schichtkombination, AlAs dar, das mit einer Schichtdicke von 1 nm oder kleiner als eine Art AlAs-Zwischenschicht an geeigneter Stelle innerhalb des Halbleitermaterialsystems integriert wird.

In bevorzugter Weise wird die erfindungsgemäß ausgebildete Blockadeschicht bspw. in der vorstehenden Form als AlAs-Schicht in die in Elektronentransportrichtung letzte Halbleiterschicht innerhalb des optischen Bereiches, die unmittelbar an die erste Halbleiterschicht innerhalb des Übergangsbereiches angrenzt, integriert. Besteht bspw. die betrefflich letzte Halbleiterschicht innerhalb des optischen Bereiches aus einer 3 Nanometer dicken AllnAs-Schicht, die selbst als Barrierenschicht dient, so wird diese Schicht ersetzt durch folgende Sandwich-Struktur mit den nachfolgenden Einzelschichtdicken: AllnAs (0,9 nm), AlAs (0,7 nm), AlInAs (0,9 nm).

Die Dickenwahl der verstehenden, in Sandwich-Struktur aneinandergefügten Einzelschichten erfolgt dabei unter der Maßgabe, dass sich die Tunnelwahrscheinlichkeit für Elektronen, die sich auf dem unteren Energieniveau E₁ innerhalb des optischen Bereiches befinden, nicht wesentlich verändert wird, so dass die Gesamtdicke der erzeugten Sandwichschicht in Regel geringer bemessen ist als die ursprüngliche AlInAs-Schicht. Andererseits reicht das Vorsehen einer derart konfigurierten, mit der Blockadeschicht versehenen Sandwichschicht aus, Elektronen im oberen Energieniveau E₃ daran zu hindern, durch die Blockadeschicht hindurchzutreten, zumal auch die bei hochenergetischen Elektronen vorhandene Tunnelwahrscheinlichkeit in Konkurrenz zu sehen ist mit der erwünschten strahlenden Übergang der hochenergetischen Elektronen im oberen Energieniveau E₃ in das untere Energieniveau E₂, der unter stimulierter Lichtemission erfolgt. In Anbetracht dieser physikalischen Konkurrenzsituation zwischen der theoretischen Tunnelwahrscheinlichkeit und des Energieübergangs zwischen den Subbändem E₃ und E₂ dient die Blockadeschicht als effektive Maßnahme gegen ein Verlust behaftetes Entweichen der Elektronen ins energetische Kontinuum. Auf diese Weise bleiben die Elektronen für den erwünschten strahlenden Prozess erhalten, woraus eine Verbesserung der Eigenschaften in Punkto Laserschwelle, maximale Arbeitstemperatur sowie maximale Ausgangsleistung im Vergleich zum reinen Bragg-Reflektor resultiert.
So haben Versuche bestätigt, dass das Auftreten von Tunnelereignissen bei Elektronen im oberen Energieniveau E₃ durch eine konventionelle AlInAs-Barrierenschicht ohne Vorsehen einer zusätzlichen Blockadeschicht verglichen mit dem Fall mit dem Vorsehen einer Blockadeschicht um den Faktor 4 reduziert werden kann. In beiden vorstehend genannten Fällen ist der Übergangsbereich als Bragg-Reflektor ausgebildet gewesen.

Neben dem Vorsehen nur einer einzigen Blockadeschicht, vorzugsweise unmittelbar im Grenzbereich zwischen dem optischen und dem Übergangsbereich innerhalb einer Halbleiter-Vielschichtstruktur können natürlich auch zwei und mehr Blockadeschichten an geeigneten Stellen innerhalb der Halbleiter-Vielschichtstruktur vorgesehen werden, mit dem Ziel das Entweichen von Elektronen aus dem oberen Energieniveau in das energetische Kontinuum zu vermeiden. Diesbezügliche Ausführungsbeispiele können im Weiteren unter Bezugnahme auf die entsprechenden Figuren im Einzelnen entnommen werden.

Ein weiterer, besonderer Aspekt beim Vorsehen einer oder mehrerer aus AlAs bestehenden Blockadeschichten betrifft ihre unterschiedliche Gitterstruktur verglichen zu den gängigen, für Quantenkaskadenlaser eingesetzten Halbleitermaterialien, wie bspw. GaInAs/AlInAs, InGaAs/AlAsSb, die üblicherweise auf einem InP-Grundsubstrat gitterangepasst sind oder InAs/AlSb, das auf ein binäres GaSb- oder InAs-Grundsubstrat gitterangepasst ist.

Durch das Vorsehen bspw. einer AlAs-Schicht innerhalb der betreffenden, bekannten Halbleiterschichtkombinationen stellt sich aufgrund der unterschiedlichen Gitterstrukturen unvermeidbar eine intrinsische Gitterverspannung ein, wodurch die Integration nur einer begrenzten Anzahl von Blockadeschichten innerhalb der jeweiligen Halbleiter-Vielschichtstrukturen möglich ist. Überdies können auch die Dicken der als Blockadeschichten wirkenden AlAs-Schichten nur begrenzt variiert werden, ohne dabei die Morphologie des Halbleitermaterialsystems zu schädigen. Zur Lösung bzw. Beseitigung dieses Problems weist InAs eine Gitterfehlanpassung zu den entsprechenden Grundsubstraten bzw. Halbleitermatrialsystemen in genau umgekehrter Weise zu der vorstehend genannten durch AlAs induzierten Gitterverspannung auf, so dass durch Vorsehen einer oder entsprechend mehrerer InAs-Schichten die durch die AlAs-Schicht bzw. Schichten hervorgerufene Gitterverspannung gerade kompensiert werden kann.

Lage, Dicke und Anzahl der vorzusehenen InAs-Schichten innerhalb der Halbleiter-Vielschichtstrukturen sind nach Maßgabe der in diesen vorhandenen Blockadeschichten zur weitgehend vollständigen Beseitigung der Gitterverspannung zu wählen. Auf entsprechende Ausführungsbeispiele, in denen mehr als eine AlAs- und zugleich auch InAs-Schicht vorgesehen ist, wird im Weiteren im Einzelnen Bezug genommen.

Die vor- und nachstehenden Ausführungen beziehen sich auf Halbleiter-Materialsysteme, die für den Ladungsträgertransport von Elektronen konzipiert sind. Grundsätzlich lässt sich die erfindungsgemäße Maßnahme des gezielten Vorsehens wenigstens einer Blockadeschicht zur Verhinderung eines Ladungsträgervertustes auch bei Halbleitermaterialsystemen vorsehen, bei denen Löcher zum alleinigen Ladungsträgertransport beitragen. Hierbei handelt es sich um sogenannte unipolare p-leitende Quantenkaskadenlaserstrukturen, die bspw. auf der Basis eines Si/SiGe-Materialsystems beruhen.

### Kurze Beschreibung der Erfindung

Die Erfindung wird nachstehend ohne Beschränkung des allgemeinen Erfindungsgedankens anhand von Ausführungsbeispielen unter Bezugnahme auf die Zeichnung exemplarisch beschrieben. Es zeigen:
- Fig. 1: Bandschema eines erfindungsgemäß ausgebildeten Quantenkaskadenlaser mit Blockadeschicht;
- Fig. 2: Bandschema eines Quantenkaskadenlaser nach Stand der Technik,
- Fig. 3: Bandschema eines erfindungsgemäß ausgebildeten Quantenkaskadenlasers mit Blockadeschicht, bei dem der optische Übergang zwischen Miniband-Zuständen erfolgt,
- Fig. 4: Bänderschema eines erfindungsgemäß ausgebildeten Quantenkaskadenlasers mit zwei Blockadeschichten sowie
- Fig. 5: Strom-Leistungsdiagramm (I/P) eines erfindungsgemäß ausgebildeten Quantenkaskadenlasers.

### Wege zur Ausführung der Erfindung, gewerbliche Verwendbarkeit

Gleichsam der unter Bezugnahme auf Figur 2 eingeführten Verwendung der Bezugszeichen ist in Figur 1 ein Bandschema eines erfindungsgemäß ausgebildeten Quantenkaskadenlasers mit entsprechenden Bezugszeichen dargestellt.

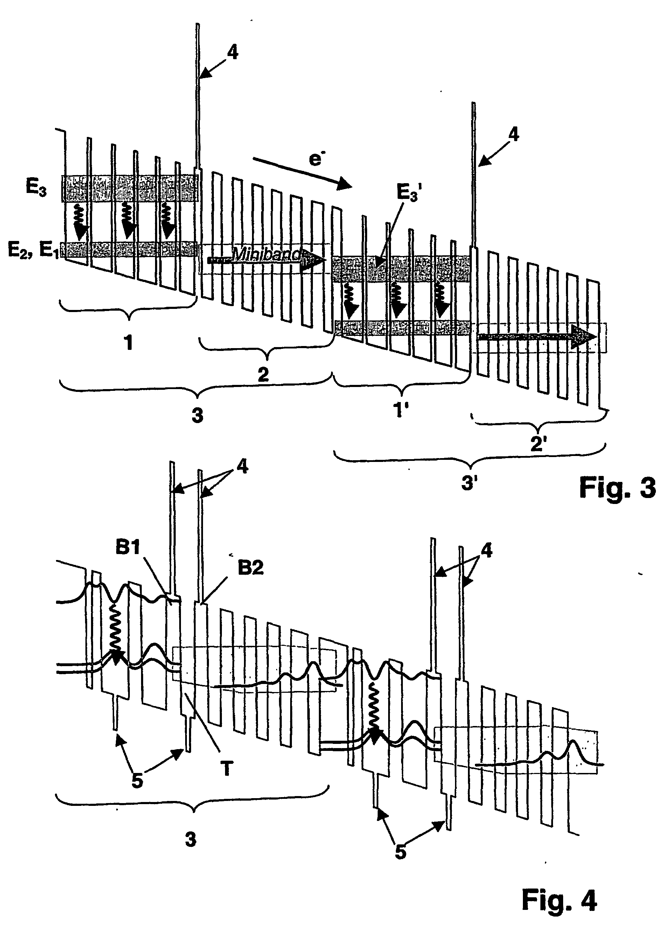

Erfindungsgemäß ist jeweils in Elektronentransportrichtung (siehe Pfeildarstellung über dem Bänderschema) die letzte Schicht innerhalb des jeweiligen optischen Bereiches 1, die an den Übergangsbereich 2 angrenzt, mit einer Blockadeschicht 4 versehen, deren obere Bandenergie gegenüber der oberen Bandenergien aller übrigen Barriereschichten B deutlich überhöht ist. Elektronen, die sich innerhalb des optischen Bereiches 1 auf dem oberen Energieniveau E₃ befinden, gelangen aufgrund der durch die Blockadeschicht 4 gebildeten lokalen Potenzialüberhöhung nicht durch diese Schicht ins energetische Kontinuum, sondern relaxieren unter Entsendung eines Photons in den Energiezustand E₂ von dem sie aus letztlich in das unterste Energieniveau E₁ gelangen. An dieser Stelle sei nochmals darauf hingewiesen, dass die Energieniveaus E₁, E₂, E₃ innerhalb des Leitungsbandes liegen und für sich genommen Subbänder darstellen. Der in Elektronentransportrichtung sich an den optischen Bereich anschließende Übergangsbereich 2 weist eine Übergitterstruktur auf und wirkt aufgrund des im Energiebereich E₃ vorhandenen Minigaps für diese hochenergetischen Elektronen als Bragg-Reflektor. Wie im weiteren unter Figur 3 gezeigt wird, gelangen die auf dem Energieniveau E₁ befindlichen Elektronen innerhalb des optischen Bereiches 1 trotz Blockadeschicht 4 nahezu unbeeinflusst in das im Übergangsbereich 2 befindliche Miniband.

Da die Blockadeschicht 4 aus einem anderen Halbleitermaterial besteht, als die für die Halbleiter-Vielschichtstruktur 3 verwendeten Halbleiterschichtkombinationen, bspw. GaInAs/AlInAs- oder InGaAs/AlAsSb-Schichtkombinationen, kommt es, wie vorstehend bereits erläutert, zu intrinsischen Gitterverspannungen innerhalb der Halbleiter-Vielschichtstruktur, die es gilt unter Verwendung einer weiteren zusätzlichen Halbleiterschicht zu kompensieren. So vermag das gezielte Vorsehen einer InAs-Schicht innerhalb der Halbleiter-Vielschichtstruktur die durch die AlAs-Schicht induzierte Gitterverspannung nahezu vollständig zu kompensieren.

Im Ausführungsbeispiel der Figur 1 ist daher im optischen Bereich 1 jeweils eine zusätzliche InAs-Schicht 5 vorgesehen, die die durch die Blockadeschicht induzierte Gitterverspannung gezielt zu kompensieren vermag. Hierdurch werden weitere Freiheitsgrade in der Schichtdickenwahl der Blockadeschicht sowie der möglichen Anzahl der getrennt voneinander in das Halbleiterschichtsystem zu integrierenden Blockadeschichten geschaffen. Grundsätzlich sind der Anordnung sowie Anzahl der zu verwendenden Blockadeschichten keine weiteren Grenzen gesetzt, sofern sie dem Zwecke der Reduzierung des mit dem Eintreten hochenergetischer Elektronen in das energetische Kontinuum behafteten Verlustmechanismus dienen.

Bezugnehmend auf die in Figur 1 gekennzeichnete Halbleiter-Vielschichtstruktur 3, die sich aus dem optischen Bereich 1 und dem Übergangsbereich 2 zusammensetzt, und deren einzelne Halbleiterschichten mit kursiv dargestellten Bezugszeichen 1 - 18 durchnumeriert sind, wird im Weiteren ein konkretes Ausführungsbeispiel eines Quantenkaskadenlasers, der auf der Basis eine AlInAs/GaInAs-Halbleitersystems aufgebaut ist, im Einzelnen beschrieben. Die in periodischer Abfolge angeordneten Halbleitermaterialschichten bestehen im Besonderen aus folgender Hatbleitermateriaizusammensetzung: Al_{0,48} In_{0,52} As/Ga_{0,47} In_{0,53} As. Im Einzelnen betreffen die Halbleiterschichten mit den ungeraden Bezugszeichen 1, 3, 5, ..., 17 AlInAs-Schichten, wohingegen die Halbleiterschichten mit geradzahligen Bezugszeichen 2, 4, 6, ...,18 GaInAs-Schichten darstellen. Die Halbleiterschicht 4 besteht ihrerseits aus einer Sandwichstruktur die aus einer GaInAs/InAs/GaInAs-Schichtkombination besteht. Die Halbleiterschicht 7 hingegen weist eine Schichtstruktur der folgenden Form auf: AlInAs/AlAs/AlInAs. Ferner sind die Halbleiterschichten 13, 14 und 15 zusätzlich mit Silizium in einer Konzentration von 2 x 10¹⁷ cm³ dotiert. Aus der nachfolgenden Tabelle gehen die einzelnen Schichtdicken der Halbleiterschichten 1 - 17 hervor. Bezüglich der Schicht 7, in der die Blockadeschicht 4 integriert ist, ist anzumerken, dass die Schichtdicke der AlAs-Schicht derart gewählt ist, dass die Tunnelwahrscheinlichkeit für Elektronen auf dem Energieniveau E₁ im Wesentlichen unbeeinflusst bleibt. Um die durch die AlAs-Schicht induzierte Gitterverspannung zu kompensieren, ist in der Halbleiterschicht 4 eine InAs-Schicht von gleicher Dicke (0,7 nm) eingebracht.

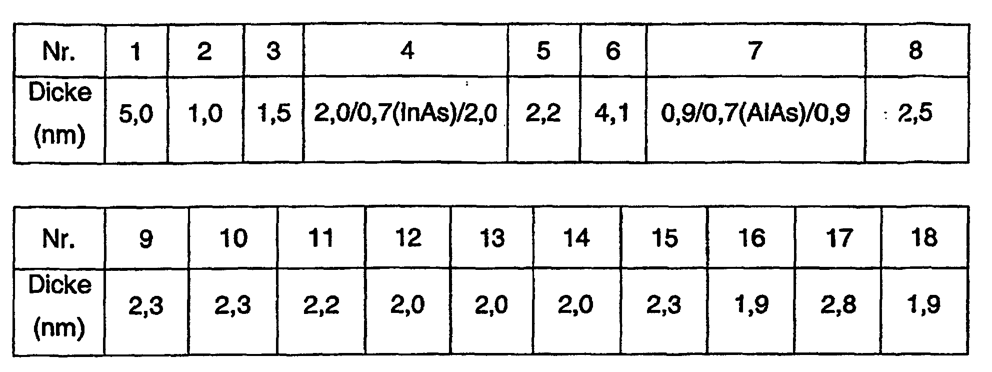

In Figur 3 ist ein Ausschnitt eines Bandschemas eines Quantenkaskadenlasers gezeigt, der zwei benachbarte Halbleiter-Vielschichtstrukturen 3, 3' zeigt. Gemäß des in Figur 3 geneigten Bandverlaufes ist die Elektronentransportrichtung gemäß Pfeildarstellung von links nach rechts anzunehmen. Elektronen, die innerhalb des optischen Bereiches 1 aus einem oberen Miniband, das dem Energieniveau E₃ entspricht, unter Lichtemission in ein unteres Miniband, das den unteren Energieniveaus E₂, E₁ entspricht, relaxieren, gelangen trotz Präsenz der Blockadeschicht 4 in das Miniband des benachbarten Übergangsbereiches 2, durch das sie in der Elektronentransportrichtung in den optischen Bereich 1' der benachbarten Halbleiter-Vielschichtstruktur 3' gelangen. Hier werden sie in das obere Miniband, entsprechend dem Energieniveau E_{3'}, injiziert, aus dem sie in die entsprechenden unteren Energieniveaus unter Lichtemission relaxieren können. Die innerhalb der Übergangsbereiche 2 vorgesehene Übergitterstruktur, die eine Bragg-Reflektor-Wirkung auf hochenergetische Elektronen ausübt, sorgt zugleich auch dafür, dass Elektronen, die sich innerhalb des Minibandes befinden, nicht in den freien Energiebereich gelangen können, sodass sie vollständig in den in Elektronensttom-Richtung vorgesehenen benachbarten optischen Bereich überführt werden können. Die in diesem Ausführungsbeispiel innerhalb der optischen Bereiche ausgebildeten Minibänder, zwischen denen Energieübergänge unter Lichtemission stattfinden, rühren von einer Übergitterstruktur auch innerhalb der optischen Bereiche her. Auch derart ausgebildete Quantenkaskadenlaser lassen sich durch die erfindungsgemäße Maßnahme, durch Vorsehen geeigneter Blockadeschichten in der angegebenen Weise optimieren.

Neben dem Vorsehen nur einer einzigen Blockadeschicht 4 innerhalb einer Halbleiter-Vielschichtstruktur 3 zeigt Figur 4 ein Ausführungsbeispiel, bei dem jeweils zwei Blockadeschichten 4 innerhalb einer Halbleiter-Vielschichtstruktur 3 angeordnet sind. Hierbei befinden sich die beiden Blockadeschichten 4 jeweils in zwei benachbarten Barriereschichten B1 und B2, wobei B1 die Grenzschicht des optischen Bereiches und die Barriereschicht B2 die benachbarte Grenzschicht bereits innerhalb des Übergangsbereiches ist. Zwischen den beiden Barriereschichten B1 und B2 ist in der dazwischenliegenden Topfschicht T eine Gitterspannungskompensationsschicht 5 vorgesehen, sowie eine weitere 5 inmitten des optischen Bereiches 1. Selbstverständlich ist es möglich mehr als zwei Blockadeschichten vorzusehen, doch ist in gleicher Weise eine entsprechende Gitterverspannungskompensationsschicht 5, vorzugsweise InAs, an entsprechender Stelle innerhalb der Halbleiter-Vielschichtstruktur einzubringen.

Schließlich wurde von Wanke et al. (Appl. Phys. Lett. 78, 3950 (2001)) eine weitere Variante eines Quantenkaskadenlasers beschrieben, bei der die der Injektorzone und des optisch aktiven Bereichs in eine einzige Übergitterstruktur als aktive Zone zusammenfalten, so dass sich als Laserkem eine periodische Wiederholung dieser Übergitterstruktur ergibt. Auch derart ausgebildete Quantenkaskadenlaser lassen sich durch die erfindungsgemäße Maßnahme, durch Vorsehen geeigneter Blockadeschichten in der angegebenen Weise optimieren. Die (im Falle dieser Publikation 3,7 nm dicke) AlInAs-Barriere, durch die die einzelnen Perioden hier voneinander getrennt werden, müsste durch eine derartige Blockadeschicht ersetzt werden.

Die vorstehend beschriebenen Ausführungsbeispiele sind, wie eingangs erwähnt, am Beispiel eines GaInAs/AlInAs-Halbleitermaterialsystems beschrieben, doch ist ihr Aufbau ebenfalls mit alternativen Halbleitermaterialsystemen wie InGaAs/AlAsSb-, GaAs/AlGaAs oder InAs/AlSb-Schichtkombinationen realisierbar. In den entsprechenden Schichtkombinationen wird die Blockadeschicht jeweils in das Barrierematerial an geeigneter Stelle, bspw. als Sandwichstruktur in folgender Weise integriert: AlInAs/AlAs/AlInAs, AlGaAs/AlAs/AlGaAs oder AlAsSb/AlAs/AlAsSb. Im Falle GaAs/AlGaAs führen die AlAs-Schichten zu keiner nennenswerten zusätzlichen Gitterverspannung, so dass hier auf den Einsatz von Kompensationsschichten verzichtet werden kann.

Neben der bevorzugten Positionierung der Blockadeschicht unmittelbar an der Grenze des optischen Bereiches zum Übergangsbereich hat es sich ebenso als vorteilhaft erwiesen, die Blockadeschicht in allen Barriereschichten innerhalb der Halbleiter-Vielschichtstruktur anzuordnen. Dies jedoch hat zur Folge, dass zur Kompensation der induzierten Gitterverspannung auch in allen Topfschichten innerhalb der Halbleiter-Vielschichtstruktur eine entsprechende, die Gitterverspannung kompensierende Schicht, vorzugsweise InAs-Schicht einzubringen ist. Durch dies Maßnahme kann die Tendenz hochenergetischer Elektronen in das energetische Kontinuum überzutreten, auf ein Minimum reduziert werden.

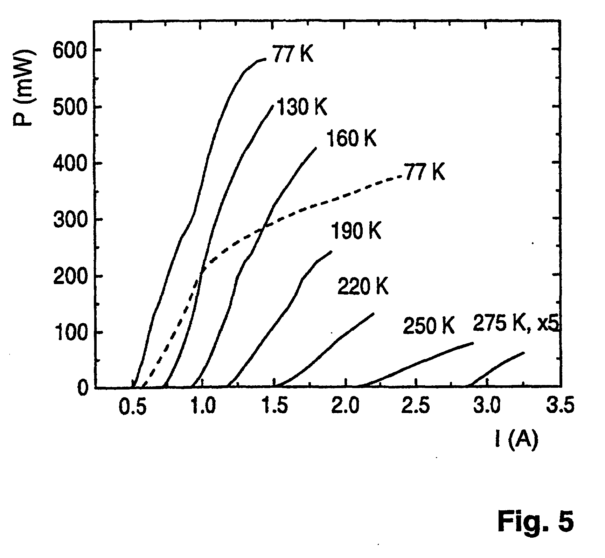

Zur Durchführung von repräsentativen Vergleichsmessungen zwischen einem erfindungsgemäß ausgebildeten Quantenkaskadenlaser sowie einem konventionellen Quantenkaskadenlaser gleicher Bauart, sind zwei ansonsten identische Quantenkaskadenlaser mit jeweils 25 in periodischer Abfolge angeordnete Halbleiter-Vielschichtstrukturen auf der Basis eines GaInAs/AlInAs-Halbleitermaterialsystem auf einem InP-Grundsubstrat aufgewachsen worden. Der erfindungsgemäß ausgebildete Quantenkaskadenlaser weist im Unterschied zu seinem konventionell ausgebildeten Vergleichspartner jeweils eine Blockadeschicht innerhalb des optischen Bereiches sowie eine die durch die Blockadeschicht induzierte Gitterverspannung kompensierende Schicht innerhalb des optischen Bereiches auf. Beide Laser sind nach geeigneter Prozessierung und Kontaktierung mit entsprechenden Kontaktelektroden mit einem elektrischen Strom beaufschlagt worden, der Strompulse mit einer Pulsdauer von 500 nsec bei einer Repititionsrate von 10 kHz aufwies. Das von dem Quantenkaskadenlaser emittierte Licht ist mit einem entsprechen kalibrierten InSb-Detektor detektiert worden, der mit Hilfe eines Fourierspektrometers spektral analysiert worden ist. In Figur 5 sind hierzu in einem Strom-Leistungs-Diagramm (I/P-Diagramm) die Messwerte der durchgeführten Vergleichsmessung dargestellt. Längs der Abszisse ist der durch den jeweiligen Quantenkaskadenlaser fließende elektrische Strom in Ampere angegeben. Längs der Ordinate sind die vom Lichtdetektor aufgenommenen Lichtleistungen in mW aufgetragen. Die im Diagramm mit durchgezogener Linie eingetragenen Funktionsverläufe entsprechen Messkurven gemessener Lichtleistungen des erfindungsgemäß ausgebildeten Quantenkaskadenlaser bei unterschiedlichen Betriebstemperaturen. So zeigt sich, dass der erfindungsgemäß ausgebildete Quantenkaskadenlaser selbst bei Betriebstemperaturen von 275° Kelvin beachtliche Lichtleistungen zu erzeugen in der Lage ist. Vergleicht man jedoch den erfindungsgemäß ausgebildeten Quantenkaskadenlaser mit dem konventionell ausgeführten Quantenkaskadenlaser ohne Blockadeschicht (siehe hierzu dies strichliert eingezeichnete Messkurve im Diagramm gemäß Figur 5) bei einer Betriebstemperatur von 77° Kelvin, so zeigt sich, dass der konventionelle Quantenkaskadenlaser eine Steilheit ("Slope Efficiency") von 610 mW/A aufweist, die einem externen Quantenwirkungsgrad von 488% entspricht. Dieser gemessene Wert entspricht in etwa einem veröffentlichten Quantenwirkungsgrad von 478% für einen bei 5 µm emittierenden Quantenkaskadenlaser mit 25-facher Stapelanordnung. Demgegenüber weist der erfindungsgemäß ausgebildete Quantenkaskadenlaser mit Blockadeschichten eine Steilheit von 866 mW/A auf, die einem externen Quantenwirkungsgrad von 693% entspricht. Dieser externe Quantenwirkungsgrad ist jedoch 40% höher als jener, der mit dem konventionellen Quantenkaskadenlaser erzielt werden konnte.

Eine weitere Besonderheit beim vorstehend beschriebenen Messvergleich der beiden Quantenkaskadenlaser betrifft die emittierte Lichtwellenlänge. Es stellt sich heraus, das der erfindungsgemäß ausgebildete Quantenkaskadenlaser durch Vorsehen der Blockadeschicht sowie der die Gitterverspannung kompensierenden zusätzlichen Schicht eine kürzere Wellenlänge (4,94 µm) emittiert als der Quantenkaskadenlaser ohne Blockadeschicht (5,08 µm). Der Unterschied in beiden Emissionswellenlängen ist durch die tiefere Topfstruktur, bedingt durch das Vorsehen der InAs-Schicht, also der die Gitterverspannung kompensierenden Schicht bedingt, wodurch der energetische Abstand zwischen dem Energieniveau E₃ und E₂ verglichen zum konventionellen Fall vergrößert wird.

Zusammenfassend können folgende Vorteile mit dem erfindungsgemäß ausgebildeten Quantenkaskadenlaser gesehen werden:
1. Erhebliche Reduzierung jener hochenergetischer Elektronen, die in das freie elektrische Kontinuum abwandern, wodurch der externe Quantenwirkungsgrad des Quantenkaskadenlasers deutlich gesteigert werden kann.
2. Durch Vorsehen einer die Gitterverspannung kompensierenden Schicht innerhalb einer aus Topfmaterial gefertigten Halbleiterschicht innerhalb des optisch aktiven Bereiches können kürzere Laserwellenlängen erzeugt werden als im Vergleich zu konventionellen Quantenkaskadenlasem.
3. Da die Blockadeschicht das Abwandern von Elektronen in das freie energetische Kontinuum effektiv zu verhindern hilft, kann der Übergangsbereich mit einem Supergitter ausgebildet werden, das über dickere Topfstrukturen verfügt und somit die Bindungsenergie innerhalb des tiefsten Minibandes reduziert. Das Vorsehen bzw. Ausbilden des Übergangsbereiches als Bragg-Reflektor kann durch das erfindungsgemäße Vorsehen der Blockadeschichten teilweise oder sogar vollständig vermieden werden.

### Bezugszeichenliste

- 1: Optischer Bereich
- 2: Übergangsbereich
- 3: Halbleiter-Vielschichtstruktur
- 4: Blockadeschicht
- 5: Kompensationsschicht

## Patentansprüche

1. Unipolarer Quantenkaskadenlaser mit einer Vielzahl von in periodischer Abfolge aneinandergrenzenden Halbleiter-Vielschichtstrukturen (3), durch die hindurch, durch Vorsehen wenigstens zweier Kontaktstellen ein Elektronenstrom einprägbar ist, und die jeweils einen optisch aktiven Bereich (1), der wenigstens eine Quantenfilmstruktur aufweist, innerhalb derer wenigstens ein oberes und ein unteres Energieniveau für Elektronen vorhanden sind, zwischen denen lichtemittierende Elektronenübergänge stattfinden, sowie einen Übergangsbereich (2) aufweisen, der eine Anzahl Halbleiterschichten aufweist, durch die hindurch Elektronen aus dem unteren Energieniveau des optisch aktiven Bereiches (1) in das obere Energieniveau eines, an den Übergangsbereich (2) in Elektronentransportrichtung unmittelbar angrenzenden optisch aktiven Bereich (1) einer benachbarten Halbleiter-Vielschichtstruktur (3) gelangen, wobei die Elektronenübergänge sowie der Elektronentransport ausschließlich im Leitungsband der Halbleiter-Vielschichtstrukturen (3) erfolgt,
**dadurch gekennzeichnet, dass** wenigstens eine zusätzliche Schicht, eine sogenannte Blockadeschicht (4), innerhalb der Halbleiter-Vielschichtstruktur (3) vorgesehen ist, die aus einem Halbleitermaterial besteht, das unterschiedlich zu den Halbleitermaterialien in der Halbleiter-Vielschichtstruktur (3) ist und die darüber hinaus ein oberstes Leitungsbandkantenpotenzial aufweist, das höher ist als die obersten Bandkantenpotenziale von allen übrigen innerhalb der Halbleiter-Vielschichtstruktur (3) enthaltenen Halbleiterschichten.

2. Unipolarer Quantenkaskadenlaser nach Anspruch 1,
**dadurch gekennzeichnet, dass** die Blockadeschicht innerhalb des optisch aktiven Bereichs in Elektronentransportrichtung unmittelbar angrenzend zum Übergangsbereich angeordnet ist.

3. Unipolarer Quantenkaskadenlaser nach Anspruch 2,
**dadurch gekennzeichnet, dass** mindestens eine weitere Blockadeschicht, identisch zur ersten Blockadeschicht ausgebildet, im Übergangsbereich vorgesehen ist.

4. Unipolarer Quantenkaskadenlaser nach Anspruch 3,
**dadurch gekennzeichnet, dass** die weitere Blockadeschicht getrennt durch wenigstens eine Halbleiterschicht, bestehend aus einem anderen Halbleitermaterial neben der ersten Blockadeschicht angeordnet ist.

5. Unipolarer Quantenkaskadenlaser nach einem der Ansprüche 1 bis 4,
**dadurch gekennzeichnet, dass** die Blockadeschicht eine Schichtdicke von 1 nm und kleiner aufweist.

6. Unipolarer Quantenkaskadenlaser nach einem der Ansprüche 1 bis 5,
**dadurch gekennzeichnet, dass** die Halbleiter-Vielschichtstruktur eine alternierende Abfolge von Halbleiterschichten aufweist, bestehend jeweils aus einem Halbleitermaterialsystem, das eine Schichtkombination zweier verschiedener Halbleitermaterialien, bestehend jeweils aus einem sogenannten Topfmaterial und einem Barrierenmaterial, vorsieht.

7. Unipolarer Quantenkaskadenlaser nach Anspruch 6,
**dadurch gekennzeichnet, dass** das Halbleitermaterialsystem aus einer GaInAs/AlInAs- oder aus einer InGaAs/AlAsSb-Schichtkombination besteht, die jeweils an InP als Grundsubstrat gitterangepasst sind.

8. Unipolarer Quantenkaskadenlaser nach Anspruch 6,
**dadurch gekennzeichnet, dass** das Halbleitermaterialsystem aus einer InAs/AlSb-Schichtkombination besteht, die an binäres GaSb oder InAs als Grundsubstrat gitterangepasst ist.

9. Unipolarer Quantenkaskadenlaser nach einem der Ansprüche 1 bis 8,
**dadurch gekennzeichnet, dass** die Blockadeschicht eine AlAs-Schicht ist.

10. Unipolarer Quantenkaskadenlaser nach einem der Ansprüche 6 bis 9,
**dadurch gekennzeichnet, dass** die Blockadeschicht derart dünn gewählt und in wenigstens einer Halbleiterschicht integriert ist, dass die Tunnelwahrscheinlichkeit für Elektronen bei der Halbleiter-Blockadeschicht bei Energien im unteren Energieniveau in etwa gleich groß ist, wie bei der Halbleiterschicht ohne Blockadeschicht.

11. Unipolarer Quantenkaskadenlaser nach einem der Ansprüche 7 bis 10,
**dadurch gekennzeichnet, dass** die AlInAs-Schicht, AlAsSb-Schicht oder AlSb-Schicht in einer Schichtkombination, die an den Übergangsbereich innerhalb einer Halbleiter-Vielschichtstruktur angrenzt, zusätzlich eine AlAs-Schicht in folgender Weise aufweist: AlInAs/AlAs/AlInAs, AlAsSb/AlAs/AlAsSb, oder AsSb/AlAs/AsSb, wobei die AlAs-Schicht jeweils die Blockadeschicht darstellt.

12. Unipolarer Quantenkaskadenlaser nach Anspruch 11,
**dadurch gekennzeichnet, dass** mindestens eine weitere AlInAs-Schicht, AlAsSb-Schicht oder AlSb-Schicht in einer Schichtkombination zusätzlich eine AlAs-Schicht in folgender Weise aufweist: AlInAs/AlAs/AlInAs, AlAsSb/AlAs/AlAsSb, oder AsSb/AlAs/AsSb, wobei die AlAs-Schicht jeweils die Blockadeschicht darstellt.

13. Unipolarer Quantenkaskadenlaser nach einem der Ansprüche 7 bis 12,
**dadurch gekennzeichnet, dass** jede AlInAs-Schicht, AlAsSb-Schicht oder AlSb-Schicht in einer Schichtkombination zusätzlich eine AlAs-Schicht in folgender Weise aufweist: AlInAs/AlAs/AlInAs, AlAsSb/AlAs/AlAsSb, oder AsSb/AlAs/AsSb, wobei die AlAs-Schicht jeweils die Blockadeschicht darstellt.

14. Unipolarer Quantenkaskadenlaser nach einem der Ansprüche 11 bis 13,
**dadurch gekennzeichnet, dass** die Schichtkombination AlInAs/AlAs/AlInAs, AlAsSb/AlAs/AlAsSb oder AsSb/AlAs/AsSb eine Schichtdicke aufweist, die in etwa die gleiche Schichtdicke aufweist wie die AlInAs-Schicht, AlAsSb-Schicht oder die AlSb-Schicht der jeweiligen Schichtkombination, d.h. die Halbleiterschicht jeweils ohne die Blockadeschicht.

15. Unipolarer Quantenkaskadenlaser nach einem der Ansprüche 9 bis 14,
**dadurch gekennzeichnet, dass** innerhalb des aktiven Bereiches eine InAs-Schicht vorgesehen ist.

16. Unipolarer Quantenkaskadenlaser nach Anspruch 15,
**dadurch gekennzeichnet, dass** die Lage und die Dicke der InAs-Schicht derart gewählt sind, dass die durch die AlAs-Blockadeschicht induzierte Gitterverspannung kompensiert ist.

17. Unipolarer Quantenkaskadenlaser nach einem der Ansprüche 9 bis 16,
**dadurch gekennzeichnet, dass** innerhalb des Übergangsbereiches mindestens eine weitere AlAs-Schicht sowie eine weitere InAs-Schicht vorgesehen ist.

18. Unipolarer Quantenkaskadenlaser nach einem der Ansprüche 9 bis 17,
**dadurch gekennzeichnet, dass** innerhalb des Übergangsbereiches eine AlAs-Schicht sowie eine InAs-Schicht vorgesehen ist.

19. Unipolarer Quantenkaskadenlaser nach einem der Ansprüche 6 bis 18,
**dadurch gekennzeichnet, dass** zu jeder AlAs-Blockadeschicht innerhalb des aktiven Bereiches jeweils eine InAs-Schicht vorgesehen ist, die die durch die AlAs-Blockadeschicht induzierte Gitterverspannung kompensiert.

## Claims

1. An unipolar quantum cascade laser comprising a plurality of adjacent semiconductor multilayer structures (3) arranged in a periodic sequence through which an electron flow can be generated by providing at least two contact points, each of the multilayer structures having an optically active area (1) comprising at least one quantum film structure in which there is at least one upper energy level and one lower energy level for the electrons, between which said levels light emitting electron transitions occur, as well as having a transition area (2) comprising a plurality of semiconductor layers through which electrons from the lower energy level of said optically active area (1) pass into the upper energy level of an optically active area (1) of an adjacent semiconductor multilayer structure (3), which is directly adjacent to the transition area (2) in the direction of electron transport, wherein the electron transitions and the electron transport occur solely in the conduction band of the semiconductor multilayer structures (3),
wherein provided in the semiconductor multilayer structure (3) is at least one additional layer, a so-called blocking layer (4), which is composed of a semiconductor material, which differs from the semiconductor materials in said semiconductor multilayer structure (3) and which, moreover, has an uppermost conduction band edge potential that is higher than the uppermost band edge potentials of all the other semiconductor layers contained inside the semiconductor multilayer structure (3).

2. The unipolar quantum cascade laser according to claim 1,
wherein said blocking layer inside the optically active area is arranged directly adjacent to said transition area in the electron transport direction.

3. The unipolar quantum cascade laser according to claim 2,
wherein at least one further blocking layer, identically designed as said first blocking layer, is provided in said transition area.

4. The unipolar quantum cascade laser according to claim 3,
wherein said further blocking layer is disposed beside said first blocking layer separated by at least one semiconductor layer composed of a different semiconductor material.

5. The unipolar quantum cascade laser according to one of the claims 1 to 4,
wherein said blocking layer has a layer thickness of 1 nm and less.

6. The unipolar quantum cascade laser according to one of the claims 1 to 5,
wherein said semiconductor multilayer structure has an alternating sequence of semiconductor layers, each of which being composed of a semiconductor material system provided with a layer combination of two different semiconductor materials, each of which is composed of a so-called pot material and a barrier material.

7. The unipolar quantum cascade laser according to claim 6,
wherein said semiconductor material system comprises a GaInAs/AlInAs layer combination or an InGaAs/AlAsSb layer combination, which are each lattice-adapted to InP as the base substrate.

8. The unipolar quantum cascade laser according to claim 6,
wherein said semiconductor material system comprises an InAs/AlSb layer combination, which is lattice-adapted to a binary GaSb or binary InAs base substrate.

9. The unipolar quantum cascade laser according to one of the claims 1 to 8,
wherein said blocking layer is an AlAs layer.

10. The unipolar quantum cascade laser according to one of the claims 6 to 9,
wherein said blocking layer is selected so thin and integrated in at least one said semiconductor layer that the tunneling probability of electrons is approximately the same in said semiconductor-blocking layer at energies in the lower energy level as in said semiconductor layer without said blocking layer.

11. The unipolar quantum cascade laser according to one of the claims 7 to 10,
wherein said AlInAs layer, AlAsSb layer or AlSb layer in a layer combination, which is adjacent to the transition area inside a semiconductor multilayer structure, is provided in addition with an AlAs layer in the following manner: AlInAs/AlAs/AlInAs, AlAsSb/AlAs/AlAsSb or AsSb/AlAs/AsSb, with said AlAs layer always representing the blocking layer.

12. The unipolar quantum cascade laser according to claim 11,
wherein at least one further AlInAs layer, AlAsSb layer or AlSb layer in a layer combination is provided in addition with an AlAs layer in the following manner: AlInAs/AlAs/AlInAs, AlAsSb/AlAs/AlAsSb or AsSb/AlAs/AsSb, with said AlAs layer always representing the blocking layer.

13. The unipolar quantum cascade laser according to one of the claims 7 to 12,
wherein each said AlInAs layer, AlAsSb layer or AlSb layer in a layer combination is provided in addition with an AlAs layer in the following manner: AlInAs/AlAs/AlInAs, AlAsSb/AlAs/AlAsSb or AsSb/AlAs/AsSb, with said AlAs layer always representing the blocking layer.

14. The unipolar quantum cascade laser according to one of the claims 11 to 13,
wherein said layer combination AlInAs/AlAs/AlInAs, AlAsSb/AlAs/AlAsSb or AsSb/AlAs/AsSb has a layer thickness which is approximately the same layer thickness as said AlInAs layer, AlAsSb layer or said AlSb layer of the respective layer combination, i.e. the semiconductor layer without the blocking layer.

15. The unipolar quantum cascade laser according to one of the claims 9 to 14,
wherein an InAs layer is provided inside said active area.

16. The unipolar quantum cascade laser according to claim 15,
wherein the location and the thickness of said InAs layer is selected in such a manner that the lattice tension induced by said AlAs blocking layer is compensated.

17. The unipolar quantum cascade laser according to one of the claims 9 to 16,
wherein at least one further AlAs layer as well as a further InAs layer are provided inside said transition area.

18. The unipolar quantum cascade laser according to one of the claims 9 to 17,
wherein an AlAs layer as well as an InAs layer are provided inside said transition area.

19. The unipolar quantum cascade laser according to one of the claims 6 to 18,
wherein an InAs layer, which compensates said lattice tension induced by said AlAs blocking layer, is provided for each AlAs blocking layer inside said active area.

## Revendications

1. Laser unipolaire à cascade quantique comprenant une multitude de structures multicouches à semi-conducteurs (3) adjacentes en suite périodique à travers lesquelles, en prévoyant au moins deux points de contact, on peut faire passer un courant électronique et qui présentent respectivement une zone active au niveau optique (1) qui comporte au moins une structure de film quantique à l'intérieur de laquelle se trouvent au moins un niveau énergétique supérieur et inférieur pour les électrons, entre lesquels ont lieu des transitions d'électrons émettant de la lumière, ainsi qu'une zone de transition (2) qui présente un certain nombre de couches de semi-conducteurs, à travers lesquelles les électrons du niveau énergétique inférieur de la zone active au point de vue optique (1) arrivent dans le niveau énergétique supérieur d'une zone active au niveau optique (1) immédiatement adjacente à la zone de transition (2), dans le sens de transport des électrons, d'une structure multicouche à semi-conducteurs voisine (3), les transitions d'électrons ainsi que le transport d'électrons ayant lieu exclusivement dans la bande de conduction des structures multicouches à semi-conducteurs (3),
**caractérisé en ce qu'**il est prévu au moins une couche supplémentaire, couche dite de blocage (4), à l'intérieur de la structure multicouche à semi-conducteurs (3), qui est composée d'un matériau à semi-conducteurs qui est différent des matériaux à semi-conducteurs de la structure multicouche à semi-conducteurs (3) et qui présente en outre un potentiel de limite de bande de conduction le plus élevé qui est plus élevé que les potentiels de limite de bande les plus élevés de toutes les autres couches à semi-conducteurs contenues à l'intérieur de la structure multicouche à semi-conducteurs (3).

2. Laser unipolaire à cascade quantique selon la revendication 1,
**caractérisé en ce que** la couche de blocage est disposée à l'intérieur de la zone active au niveau optique, dans le sens de transport des électrons, de manière directement adjacente à la zone de transition.

3. Laser unipolaire à cascade quantique selon la revendication 2,
**caractérisé en ce qu'**il est prévu au moins une autre couche de blocage, réalisée de manière identique à la première couche de blocage, dans la zone de transition.

4. Laser unipolaire à cascade quantique selon la revendication 3,
**caractérisé en ce que** l'autre couche de blocage, séparée par au moins une couche de semi-conducteurs et constituée d'un autre matériau à semi-conducteurs, est disposée près de la première couche de blocage.

5. Laser unipolaire à cascade quantique selon l'une quelconque des revendications 1 à 4,
**caractérisé en ce que** la couche de blocage présente une épaisseur de couche de 1 nm et moins.

6. Laser unipolaire à cascade quantique selon l'une quelconque des revendications 1 à 5,
**caractérisé en ce que** la structure multicouche à semi-conducteurs présente une suite alternante de couches de semi-conducteurs, composées respectivement d'un système de matériau à semi-conducteurs qui prévoit une combinaison de couches de deux matériaux à semi-conducteurs différents, composées chacune d'un matériau dit formant puits et d'un matériau formant barrière.

7. Laser unipolaire à cascade quantique selon la revendication 6,
**caractérisé en ce que** le système de matériau à semi-conducteurs est fait d'une combinaison de couches de GaInAs/AlInAs ou d'InGaAs/AlAsSb, qui sont respectivement adaptées au niveau grille à de l'InP servant de substrat de base.

8. Laser unipolaire à cascade quantique selon la revendication 6,
**caractérisé en ce que** le système de matériau à semi-conducteurs est fait d'une combinaison d'InAs/AlSb, qui est adaptée au niveau grille à du GaSb ou de l'InAs binaire servant de substrat de base.

9. Laser unipolaire à cascade quantique selon l'une quelconque des revendications 1 à 8,
**caractérisé en ce que** la couche de blocage est une couche d'AlAs.

10. Laser unipolaire à cascade quantique selon l'une quelconque des revendications 6 à 9,
**caractérisé en ce que** la couche de blocage est choisie mince et est intégrée dans au moins une couche de semi-conducteurs, que la probabilité de tunnel pour les électrons dans la couche de blocage à semi-conducteurs, en cas d'énergie de niveau énergétique inférieur, est approximativement égale à ce qu'elle est pour la couche de semi-conducteurs sans couche de blocage.

11. Laser unipolaire à cascade quantique selon l'une quelconque des revendications 7 à 10,
**caractérisé en ce que** la couche d'AlInAs, la couche d'AlAsSb ou la couche d'AlSb présente, en une combinaison de couches qui est adjacente à la zone de transition à l'intérieur d'une structure multicouche à semi-conducteurs, en outre une couche d'AlAs de la manière suivante : AlInAs/AlAs/AlInAs, AlAsSb/AlAs/AlAsSb ou AsSb/AlAs/AsSb, la couche d'AlAs constituant respectivement la couche de blocage.

12. Laser unipolaire à cascade quantique selon la revendication 11,
**caractérisé en ce qu'**au moins une autre couche d'AlInAs, une couche d'AlAsSb ou une couche d'AlSb présente, dans une combinaison de couches, en plus une couche d'AlAs de la manière suivante : AlInAs/AlAs/AlInAs, AlAsSb/AlAs/AlAsSb ou AsSb/AlAs/AsSb, la couche d'AlAs constituant respectivement la couche de blocage.

13. Laser unipolaire à cascade quantique selon l'une quelconque des revendications 7 à 12,
**caractérisé en ce que** chaque couche d'AlInAs, couche d'AlAsSb ou couche d'AlSb présente, dans une combinaison de couches, en plus une couche d'AlAs de la manière suivante : AlInAs/AlAs/AlInAs, AlAsSb/AlAs/AlAsSb ou AsSb/AlAs/AsSb, la couche d'AlAs constituant respectivement la couche de blocage.

14. Laser unipolaire à cascade quantique selon l'une quelconque des revendications 11 à 13,
**caractérisé en ce que** la combinaison de couches AlInAs/AlAs/AlInAs, AlAsSb/AlAs/AlAsSb ou AsSb/AlAs/AsSb présente une épaisseur de couche qui présente approximativement la même épaisseur de couche que la couche d'AlInAs, la couche d'AlAsSb ou la couche d'AlSb de la combinaison de couches respective, c'est-à-dire la couche de semi-conducteurs respectivement sans couche de blocage.

15. Laser unipolaire à cascade quantique selon l'une quelconque des revendications 9 à 14,
**caractérisé en ce qu'**il est prévu, à l'intérieur de la zone active, une couche d'InAs.

16. Laser unipolaire à cascade quantique selon la revendication 15,
**caractérisé en ce que** la position et l'épaisseur de la couche d'InAs sont choisies de manière à ce que la tension de grille induite par la couche de blocage en AlAs soit compensée.

17. Laser unipolaire à cascade quantique selon l'une quelconque des revendications 9 à 16,
**caractérisé en ce qu'**il est prévu, à l'intérieur de la zone de transition, au moins une autre couche d'AlAs ainsi qu'une autre couche d'InAs.

18. Laser unipolaire à cascade quantique selon l'une quelconque des revendications 9 à 17,
**caractérisé en ce qu'**il est prévu, à l'intérieur de la zone de transition, une couche d'AlAs ainsi qu'une couche d' InAs.

19. Laser unipolaire à cascade quantique selon l'une quelconque des revendications 6 à 18,
**caractérisé en ce que**, pour chaque couche de blocage en AlAs à l'intérieur de la zone active, il est prévu respectivement une couche d'InAs qui compense la tension de grille induite par la couche de blocage en AlAs.
